# EUROPEAN PATENT APPLICATION

(11) **EP 3 666 936 A1**
(43) Date of publication of application: **17.06.2020**
(21) Application number: 18922091.6
(22) Date of filing: 26.12.2018
(51) Int. Cl.: C30B 23/02, C30B 29/36, C30B 33/02

(54) **SEMI-INSULATING SILICON CARBIDE SINGLE CRYSTAL DOPED WITH SMALL AMOUNT OF VANADIUM, SUBSTRATE PREPARED THEREFROM, AND PREPARATION METHOD THEREFOR**

(30) Priority: 16.10.2018 CN 201811204690; 16.10.2018 CN 201811204702
(71) Applicant: SICC Co., Ltd, Shandong 250100 (CN)
(72) Inventor: The designation of the inventor has not yet been filed
(74) Representative: Bergenstråhle Group AB
(86) International application number: PCT/CN2018/123707
(87) International publication number: WO 2020/077846

(57) **Abstract**

The present application discloses a semi-insulating silicon carbide single crystal doped with a small amount of vanadium, a substrate and a preparation method thereof, and belongs to the field of semiconductor materials. The semi-insulating silicon carbide single crystal comprises shallow-energy-level impurities, a low-concentration deep-energy-level dopant, and a very small amount of intrinsic point defects; wherein, the shallow-energy-level impurities are compensated by the deep-energy-level dopant and the intrinsic point defects together, a concentration of the deep-energy-level dopant is lower than a concentration of a deep-energy-level dopant in a doped semi-insulating silicon carbide single crystal; a concentration of the intrinsic point defects is a primary concentration of intrinsic point defects in the silicon carbide single crystal at room temperature, and stability of electrical properties of the silicon carbide single crystal is not affected by the concentration of the intrinsic point defects. The semi-insulating silicon carbide single crystal has a highly stable resistivity and has high resistivity uniformity. The silicon carbide single crystal substrate prepared from the silicon carbide single crystal has high resistivity uniformity and a low stress, so that the silicon carbide single crystal substrate has excellent surface quality, so as to guarantee stability and consistency of subsequent epitaxial quality.

## Description

### TECHNICAL FIELD

The present application relates to a high-quality semi-insulating silicon carbide single crystal doped with a small amount of vanadium, a substrate and a preparation method thereof, and belongs to the field of semiconductor materials.

### BACKGROUND

A semi-insulating silicon carbide (SiC) single crystal substrate becomes a preferred semiconductor material for preparing a GaN-based high-frequency microwave device due to its excellent physical properties such as large forbidden bandwidth, high resistivity and thermal conductivity, and strong breakdown field. With continuous development of the 5G technology, the demand for semi-insulating silicon carbide single crystal substrates has been expanding at the market; and more importantly, application of batch commercialization also puts forward higher requirements on quality of the semi-insulating silicon carbide single crystal substrates.

Preparation of a semi-insulating silicon carbide single crystal which has been industrialized at present implements a semi-insulation property by introducing high-concentration vanadium impurities as a deep-energy-level compensation center on a basis of a physical vapor transport (PVT) method, a silicon carbide single crystal thus prepared being referred to as a doped semi-insulating silicon carbide single crystal; or implements the semi-insulation property by continuously reducing concentration of shallow-energy-level impurities in the crystal and introducing a certain amount of intrinsic point defects during a crystal preparation process, a silicon carbide single crystal thus prepared being referred to as a high-purity semi-insulating silicon carbide single crystal.

Since high-concentration vanadium is introduced in the preparation process, the doped semi-insulating silicon carbide single crystal is apt to have vanadium precipitates formed in the crystal and induce microtubule defects, thereby reducing crystal quality; in addition, studies have shown that high-concentration vanadium, as an electron capture center in the device, will cause a back gate effect, which reduces or even destroys device performance. Therefore, with development of a substrate preparation technology and a device preparation technology, a high-purity semi-insulating silicon carbide single crystal substrate has gradually become a mainstream. Lower shallow-energy-level impurities in the high-purity semi-insulating silicon carbide single crystal can reduce an effective carrier concentration in the crystal, and meanwhile pin the Fermi level to a forbidden band center by introducing a specific amount of intrinsic point defects, so as to implement the semi-insulation property of the crystal. However, the intrinsic point defects have a higher migration rate in the crystal, so migration diffusion and annihilation occur at a certain temperature (e.g., under a temperature condition for preparing a GaN epitaxial layer), which causes instability of a resistivity of the substrate, and also affects stability of device performance.

A vanadium concentration [V] in the doped semi-insulating silicon carbide single crystal is usually 1×10¹⁷ cm⁻³ to 1×10¹⁸cm⁻³, and a corresponding nitrogen concentration [N] is higher than an order of 10¹⁷ cm⁻³; there is a higher technical barrier in doping high-concentration vanadium in the preparation process, and shallow-energy-level impurities having an uncontrollable concentration and containing a large amount of defects are easily formed in the prepared crystal, resulting in uncontrollable crystal quality. [N] in the high-purity semi-insulating silicon carbide single crystal is on an order of 10¹⁵ cm⁻³, and a corresponding point defect concentration is on an order of 1×10¹⁵ cm⁻³ or above, which requires higher technical costs and capital costs to remove the concentration of the shallow-energy-level impurities such as nitrogen in the preparation process.

### SUMMARY

In order to solve the above-described problems, the present application provides a high-quality lightly-doped semi-insulating silicon carbide single crystal, a substrate and a preparation method thereof; the semi-insulating silicon carbide single crystal has a more stable resistivity and does not have the precipitate defect and the electron capture problem caused by high-concentration doping; the silicon carbide single crystal substrate prepared from the silicon carbide single crystal has higher resistivity uniformity and a low stress, so that the silicon carbide single crystal substrate has excellent surface quality, and therefore, stability and consistency of subsequent epitaxial quality is ensured, and the silicon carbide single crystal substrate helps to improve device performance.

In one aspect, the present application provides a high-quality semi-insulating silicon carbide single crystal doped with a small amount of vanadium, comprising shallow-energy-level impurities, a low-concentration deep-energy-level dopant, and a very small amount of intrinsic point defects; wherein, the shallow-energy-level impurities are compensated by the deep-energy-level dopant and the intrinsic point defects together, a concentration of the deep-energy-level dopant is lower than a concentration of a deep-energy-level dopant in a doped semi-insulating silicon carbide single crystal; a concentration of the intrinsic point defects is a primary concentration of intrinsic point defects in the silicon carbide single crystal at room temperature, and stability of electrical properties of the silicon carbide single crystal is not affected by the concentration of the intrinsic point defects.

The primary concentration of the intrinsic point defects according to the present application is a concentration of intrinsic point defects formed by self-heating in a process of growing the silicon carbide single crystal, and does not include a concentration of intrinsic point defects introduced at the subsequent processing of the silicon carbide single crystal.

In the present application, the concentration of the deep-energy-level dopant in the doped semi-insulating silicon carbide single crystal is usually 5×10¹⁷ cm⁻³ to 1×10¹⁸ cm⁻³.

Optionally, the silicon carbide single crystal has its semi-insulation property implemented by introducing a small amount of deep-energy-level dopant to replace the intrinsic point defects in the silicon carbide single crystal while reducing the shallow-energy-level impurities in a silicon carbide crystal.

Optionally, a sum of concentrations of the shallow-energy-level impurities is lower than 1×10¹⁷ cm⁻³, the concentration of the deep-energy-level dopant is lower than 1×10¹⁷ cm⁻³, and the concentration of the intrinsic point defects at room temperature is not higher than 1×10¹⁵ cm⁻³. Further, the sum of the concentrations of the shallow-energy-level impurities is lower than 1×10¹⁷ cm⁻³, the concentration of the deep-energy-level dopant is lower than 1×10¹⁷ cm⁻³, and the concentration of the intrinsic point defects at room temperature is higher than 1×10¹⁵ cm⁻³.

Optionally, the concentration of the intrinsic point defects at room temperature is not higher than 1×10¹⁴ cm⁻³. Further, the concentration of the intrinsic point defects at room temperature is higher than 1×10¹⁴ cm⁻³.

Optionally, the sum of the concentrations of the shallow-energy-level impurities is not lower than 1×10¹⁵ cm⁻³, the concentration of the deep-energy-level dopant is not lower than 1×10¹⁵ cm⁻³, and the concentration of the intrinsic point defects at room temperature is not higher than 1×10¹⁴ cm⁻³. Further, the sum of the concentrations of the shallow-energy-level impurities is higher than 1×10¹⁵ cm⁻³, the concentration of the deep-energy-level dopant is higher than 1×10¹⁵ cm⁻³, and the concentration of the intrinsic point defects at room temperature is lower than 1×10¹⁴ cm⁻³.

Optionally, the sum of the concentrations of the shallow-energy-level impurities is higher than 1×10¹⁵ cm⁻³, the concentration of the deep-energy-level dopant is 5×10¹⁵ cm⁻³ to 1×10¹⁷ cm⁻³, and the concentration of the intrinsic point defects at room temperature is not higher than 1×10¹⁴ cm⁻³. Further, the sum of the concentrations of the shallow-energy-level impurities is higher than 1×10¹⁵ cm⁻³, the concentration of the deep-energy-level dopant is 5×10¹⁵ cm⁻³ to 1×10¹⁷ cm⁻³, and the concentration of the intrinsic point defects at room temperature is lower than 1×10¹⁴ cm⁻³.

Preferably, the sum of the concentrations of the shallow-energy-level impurities is not lower than 5×10¹⁵ cm⁻³. Further, the sum of the concentrations of the shallow-energy-level impurities is higher than 5×10¹⁵ cm⁻³.

More preferably, the sum of the concentrations of the shallow-energy-level impurities is not lower than 1×10¹⁶ cm⁻³. Further, the sum of the concentrations of the shallow-energy-level impurities is higher than 1×10¹⁶ cm⁻³.

Preferably, the concentration of the deep-energy-level dopant is 1×10¹⁶ cm⁻³ to 5×10¹⁶ cm⁻³.

Preferably, a defect concentration of the intrinsic point defects is not higher than an intrinsic concentration at room temperature.

Preferably, the defect concentration of the intrinsic point defects is not higher than 1×10¹² cm⁻³. Further, the defect concentration of the intrinsic point defects is lower than 1×10¹² cm⁻³.

Optionally, a mean resistivity change value of the silicon carbide single crystal before and after an epitaxial annealing process is less than 55%.

Optionally, the silicon carbide single crystal may be prepared into a single crystal substrate, and the epitaxial annealing process includes: holding a temperature of 900 °C to 1,200 °C for 0.5 h to 10 h.

Optionally, a mean resistivity change value of the silicon carbide single crystal before and after the treatment of holding the temperature of 900 °C to 1,200 °C for 0.5 h to 10 h is less than 55%.

Preferably, the mean resistivity change value of the silicon carbide single crystal before and after the treatment of holding the temperature of 900 °C to 1,200 °C for 0.5 h to 10 h is less than 50%; further, the mean resistivity change value of the silicon carbide single crystal before and after the treatment of holding the temperature of 900 °C to 1,200 °C for 0.5 h to 10 h is less than 30%

Optionally, the shallow-energy-level impurities include one or more of the IIIA and VA main family elements in the periodic table of elements.

Optionally, the shallow-energy-level impurities include one or more of nitrogen, boron and aluminum.

Preferably, the shallow-energy-level impurities include nitrogen, boron and aluminum.

Optionally, the deep-energy-level dopant is selected from at least one of the VB family elements in the periodic table of elements.

Preferably, the deep-energy-level dopant is vanadium.

Optionally, a crystal form of the silicon carbide crystal is 4H-SiC, 6H-SiC or 3C-SiC. Further, the crystal form of the silicon carbide single crystal is 4H-SiC.

Optionally, a resistivity of the silicon carbide crystal is greater than 1×10¹¹ Ω·cm; further, the resistivity of the silicon carbide crystal is greater than 3×10¹¹ Ω·cm, and more further, the resistivity of the silicon carbide crystal is greater than 6×10¹¹ Ω·cm.

According to another aspect of the present application, there is provided a preparation method of a high-quality semi-insulating silicon carbide single crystal doped with a small amount of vanadium, comprising steps of:
1) Removing impurities of a thermal field device;
2) Mixing materials: doping a deep-energy-level dopant into a silicon carbide powder;
3) Crystal growth: starting crystal growth after placing the silicon carbide powder doped with the deep-energy-level dopant prepared in step 2) in the thermal field device treated in step 1), a concentration of a deep-energy-level doping center element after an end of crystal growth being 5×10¹⁵ cm⁻³ to 1×10¹⁷ cm⁻³;
4) Annealing: annealing a silicon carbide single crystal initial product treated in step 3), to obtain the silicon carbide single crystal.

Optionally, the semi-insulating silicon carbide single crystal is prepared by using a method comprising steps of:
1) Removing impurities of a thermal field device: performing high-temperature purification on a graphite thermal insulation structure and a graphite crucible;
2) Mixing materials: doping a deep-energy-level dopant element in a silicon carbide powder, a concentration of the deep-energy-level dopant in the silicon carbide powder being 1×10¹⁶ cm⁻³ to 1×10¹⁷ cm⁻³;
3) Crystal growth: starting a crystal growth step after placing the silicon carbide powder doped with the deep-energy-level dopant element prepared in step 2) in the graphite crucible treated in step 1), a concentration of a deep-energy-level doping center element after an end of the crystal growth step being 5×10¹⁵ cm⁻³ to 1×10¹⁷ cm⁻³;
4) Annealing: annealing the silicon carbide single crystal treated in step 3).

Preferably, the crystal growth step includes a high-temperature pretreatment stage and a crystal growth stage.

The deep-energy-level dopant element is selected from at least one of the VB family elements in the periodic table of elements.

Preferably, the deep-energy-level dopant is vanadium.

Optionally, the thermal field device includes a graphite thermal insulation structure and a graphite crucible. Further, the graphite thermal insulation structure is a graphite thermal insulation felt.

Preferably, the removing impurities of a thermal field device in step 1) includes: holding a temperature of 1,800 °C to 2,500 °C and a pressure of 5 mbar to 50 mbar for 20 h to 100 h after placing the silicon carbide powder in the graphite crucible. Further, the removing impurities of a thermal field device in step 1) includes: holding a temperature of 2,200 °C to 2,400 °C and a pressure of 20 mbar to 30 mbar for 50 h to 100 h after placing the silicon carbide powder in the graphite crucible.

Optionally, a concentration of the deep-energy-level dopant element in the mixture in step 2) is 1×10¹⁶ cm⁻³ to 1×10¹⁷ cm⁻³. Further, the concentration of the deep-energy-level dopant element in the mixture of step 2) is 2×10¹⁶ cm⁻³ to 5×10¹⁶ cm⁻³.

Optionally, the crystal growth step in step 3) includes: a high-temperature pretreatment stage and a crystal growth stage;

A condition for the high-temperature pretreatment stage is: holding a temperature of 1,200 °C to 2,000 °C and a pressure of 800 mbar to 1,000 mbar for 5 h to 50 h;

A condition for the crystal growth stage is: reducing the pressure to 5 mbar to 50 mbar while raising a temperature to above 2,200 °C at a rate of 10 °C/min to 50 °C/min. The method of the crystal growth stage allows the silicon carbide powder in the graphite crucible to be fully sublimated.

Further, the crystal growth step in step 3) includes: a high-temperature pretreatment stage and a crystal growth stage;

A condition for the high-temperature pretreatment stage is: holding a temperature of 1,800 °C to 2,000 °C and a pressure of 800 mbar to 900 mbar for 30 h to 50 h;

A condition for the crystal growth stage is: reducing the pressure to 5 mbar to 50 mbar while raising the temperature to above 2,200 °C at a rate of 10 °C/min to 30 °C/min.

Optionally, a condition for annealing in step 4) is: placing the silicon carbide single crystal initial product of step 3) in an annealing furnace and holding a temperature of 1,800 °C to 2,200 °C for 10 h to 50 h. Further, a condition for annealing in step 4) is: placing the silicon carbide single crystal initial product of step 3) in the annealing furnace and holding a temperature of 2,000 °C to 2,200 °C for 30 h to 50 h.

As an implementation mode, the semi-insulating silicon carbide single crystal is prepared by using a method including steps of:
(1) Performing high-temperature purification on the graphite thermal insulation felt and the graphite crucible used for crystal growth of the silicon carbide single crystal. The silicon carbide powder is placed in the graphite crucible, with a particle size of the powder controlled at 50 µm to 500 µm, and a quantity controlled at 50% to 80% of a volume of the crucible; the graphite crucible is placed in the graphite thermal insulation felt and packaged into a silicon carbide crystal growth furnace, to undergo a high-temperature treatment at a temperature of 1,800 °C to 2,500 °C and a pressure of 5 mbar to 50 mbar for 20 h to 100 h. In the step, the powder in the crucible is sublimated to form a high-temperature vapor; the high-temperature vapor can infiltrate into the graphite crucible and the graphite thermal insulation felt during a dissipating process and expel impurity elements such as nitrogen adsorbed thereby, so as to obtain a high-purity graphite material.
(2) Uniformly doping a vanadium element in the silicon carbide powder. The doping of the vanadium element in a synthesis process of the silicon carbide powder may be carried out by mixing with the silicon carbide powder, or may also be inlaid in a graphite container and then buried in the mixed silicon carbide powder. In order to control a doping concentration of vanadium which is subsequently introduced into the silicon carbide single crystal, the vanadium doping concentration in the silicon carbide powder should be controlled accordingly: 0.01 g to 1 g of the vanadium element should be placed in each 1 kg of reaction source powder, and its concentration in the silicon carbide powder after the reaction should be on an order of 1×10¹⁶ cm⁻³ to 1×10¹⁷ cm⁻³, in order to implement a content range of a small amount of vanadium in the subsequent crystal growth process. Specifically, disclosed patent documents may be referred to for the reaction process of the silicon carbide powder after uniformly mixing vanadium with the silicon carbide powder or placing vanadium with the doping concentration in the graphite container.
(3) Starting crystal growth after obtaining, through the reaction, a silicon carbide powder containing vanadium with a certain doping concentration, placing the silicon carbide powder doped with a small amount of vanadium in the graphite crucible and packaging the same into a crystal growth furnace. The crystal growth process includes a high-temperature pretreatment at 1,200 °C to 2,000 °C and 800 mbar to 1,000 mbar for 5 h to 50 h to remove impurities such as nitrogen adsorbed in the furnace. The present application has a small amount of vanadium introduced, and thus, as compared with a case of the high-purity semi-insulating silicon carbide single crystal, greatly simplifies a purification process of the step by merely removing excess nitrogen, which can reduce technical costs and seed crystal costs as compared with the preparation process of the high-purity semi-insulating silicon carbide single crystal. After the purification pretreatment in the furnace is completed, the pressure is reduced to 5 mbar to 50 mbar, while the temperature is raised to above 2,200 °C at a rate of 10 °C/min to 30 °C/min, so that the silicon carbide powder doped with a small amount of vanadium in the graphite crucible is fully sublimated. A sublimated vapor and the released vanadium element are transported to the seed crystal along with a temperature gradient to crystallize. It can be known from a growth process of a heavily-doped semi-insulating silicon carbide single crystal that, the vanadium element occupies a part of lattice positions of a crystal growth interface during the crystal growth process, so as to implement doping of the vanadium element. The vanadium element contained in the silicon carbide powder doped with a small amount of vanadium has been limited to a content of 1×10¹⁶ cm⁻³ to 1×10¹⁷ cm⁻³, so after a vapor transport process, the concentration of the vanadium element finally doped into the crystal should be between 5×10¹⁵ cm⁻³ and 1×10¹⁷ cm⁻³ with loss in the transport process and recombination of the vanadium element and the silicon carbide powder taken into account. The vanadium element entering the silicon carbide single crystal may exist both as a donor and as an acceptor, so as to compensate for the shallow-energy-level impurities in the silicon carbide single crystal.
(4) Taking the silicon carbide single crystal out of the graphite crucible after the growth of the silicon carbide single crystal is completed. Since the growth interface is at a relatively high temperature during the growth of the silicon carbide single crystal, some atoms at the growth interface break away from lattice positions to form intrinsic point defects of a certain concentration. By placing the silicon carbide single crystal in the annealing furnace and annealing at a temperature of 1,800 °C to 2,000 °C for 10 h to 50 h, the intrinsic point defects may be removed. In the annealing process, the intrinsic point defects existing in the silicon carbide single crystal annihilate through migration, and the concentration of the intrinsic point defects is lowered to such a level that does not affect the electrical properties of the crystal.

The resistivity of the silicon carbide single crystal prepared in the present application is determined by residual shallow-energy-level impurities and a small amount of vanadium. Since the shallow-energy-level impurities and a small amount of vanadium all occupy lattice positions, they have very high thermal stability, which means that the silicon carbide single crystal according to the present application can obtain a highly stable resistivity.

In the present application, ranges indicated by expressions of "not higher than", "not lower than", "higher than" and "lower than" include endpoint values.

According to another aspect of the present application, there is provided a semi-insulating silicon carbide single crystal substrate, prepared from any one of the above-described semi-insulating silicon carbide single crystals or from the semi-insulating silicon carbide single crystal prepared by using any one of the above-described methods.

According to still another aspect of the present application, there is provided a preparation method of a high-quality semi-insulating silicon carbide single crystal substrate doped with a small amount of vanadium, comprising cutting and polishing any one of the above-described high-quality semi-insulating silicon carbide single crystal doped with a small amount of vanadium, to obtain the semi-insulating silicon carbide single crystal substrate.

Optionally, a mean resistivity change value of the silicon carbide single crystal substrate before and after an epitaxial annealing process is less than 55%.

Optionally, a mean resistivity change value of the silicon carbide single crystal before and after a treatment of holding a temperature of 900 °C to 1,200 °C for 0.5 h to 10 h is less than 55%.

Further, the mean resistivity change value of the silicon carbide single crystal substrate before and after the treatment of holding the temperature of 900 °C to 1,200 °C for 0.5 h to 10 h is less than 50%; further, the mean resistivity change value of the silicon carbide single crystal substrate before and after the treatment of holding the temperature of 900 °C to 1,200 °C for 0.5 h to 10 h is less than 30%.

According to still another aspect of the present application, there is provided an epitaxial wafer and/or a transistor, comprising any one of the above-described semi-insulating silicon carbide single crystal substrates.

Advantageous effects of the present application include, but are not limited to that:
1) The silicon carbide single crystal according to the present application is a semi-insulating single crystal doped with a small amount of vanadium; and in the present application, the semi-insulation property of the silicon carbide single crystal is implemented by introducing a small amount of vanadium for doping to replace the intrinsic point defects in the silicon carbide single crystal while reducing the shallow-energy-level impurities in the silicon carbide crystal.
2) The resistivity of the silicon carbide single crystal according to the present application is determined by residual shallow-energy-level impurities and a small amount of vanadium; and since these impurities all occupy lattice positions, they have very high thermal stability, which means that the crystal can obtain a highly stable resistivity, and have high resistivity uniformity.
3) The preparation of the silicon carbide single crystal according to the present application is combined with existing preparation technologies of a doped semi-insulating silicon carbide single crystal and a high-purity semi-insulating silicon carbide single crystal, and by controlling the shallow-energy-level impurity concentration and the deep-energy-level dopant concentration in the silicon carbide crystal, can implement the semi-insulating silicon carbide single crystal and the substrate having higher resistivity stability, and at a same time, avoid the precipitate defect and the electron capture problem caused by high-concentration doping, so as to improve quality of the silicon carbide single crystal substrate and help improve performance of a device to which the substrate is applied.
4) In the silicon carbide single crystal according to the present application, the shallow-energy-level impurity concentration does not need to be lowered to a level of the high-purity semi-insulating silicon carbide single crystal, which can save costs and reduce a process difficulty.
5) As a substrate, the silicon carbide single crystal according to the present application has good electrical property stability; meanwhile, by surface tests of the silicon carbide single crystal substrate before and after annealing, changes of absolute values of Bow and Warp are far smaller than a 5-µm control line before and after annealing as required by the epitaxy process, which indicates that an inner stress of the silicon carbide single crystal substrate is extremely small, so that the substrate can be ensured to have excellent surface quality, so as to guarantee stability and consistency of the substrate quality in the subsequent epitaxy process.
6) The preparation methods of the semi-insulating single crystal/single crystal substrate doped with a small amount of vanadium according to the present application, by introducing a small amount of vanadium for doping to replace the intrinsic point defects in the crystal while reducing the shallow-energy-level impurities in the silicon carbide single crystal, implement the semi-insulation property thereof with low technical costs and capital costs.

### BRIEF DESCRIPTION OF THE DRAWINGS

FIG. 1 is a surface scanning chart of a resistivity of silicon carbide single crystal substrate 1# before annealing.
FIG. 2 is a surface scanning chart of a resistivity of silicon carbide single crystal substrate 1# after annealing.

### DETAILED DESCRIPTION

The present application is described in detail below in conjunction with the embodiments, but the present application is not limited to these embodiments.

Unless otherwise specifically stated, raw materials and the like involved in the embodiments of the present application are all commercially purchased.

The analysis methods according to the embodiment of the present application are as follows:

The crystal test of the silicon carbide single crystal is carried out with Horiba's HR800 confocal Raman spectrometer.

The surface test of the silicon carbide single crystal substrate is carried out with FRT's MicroProf@TTV200 automatic surface tester.

The resistivity test is carried out with Semimap's COREMA-WT non-contact semi-insulating resistivity tester.

The element content test is carried out with Cameca's IMS 7f-Auto secondary ion mass spectrometer.

In an implementation mode of the present application, a preparation process of the silicon carbide single crystal includes steps of:
1) Removing impurities of a thermal field device: performing high-temperature purification on a graphite thermal insulation felt and a graphite crucible;
2) Mixing materials: uniformly doping a vanadium element in a silicon carbide powder, a vanadium concentration in the silicon carbide powder being 1×10¹⁶ cm⁻³ to 1×10¹⁷ cm⁻³;
3) Crystal growth: starting crystal growth after placing the silicon carbide powder doped with vanadium prepared in step 2) in the graphite crucible treated in step 1), the crystal growth step including a high-temperature pretreatment stage and a crystal growth stage, and a vanadium concentration of after an end of the crystal growth step being 5×10¹⁵ cm⁻³∼1×10¹⁷ cm⁻³;
4) Annealing: annealing the silicon carbide single crystal treated in step 3), to obtain the semi-insulating silicon carbide single crystal.

### Embodiment 1: Preparation of semi-insulating silicon carbide single crystal-removing impurities of thermal field device

The thermal field device includes a graphite crucible and a graphite thermal insulation felt, and the graphite thermal insulation felt and the graphite crucible used in preparation of the silicon carbide single crystal are subjected to high-temperature purification. The high-temperature purification step includes: placing the silicon carbide powder in the graphite crucible, controlling a particle size of the powder at 50 µm to 500 µm, and a quantity at 50% to 80% of a volume of the crucible; placing the graphite crucible in the graphite thermal insulation felt and packaging the same into a silicon carbide crystal growth furnace; and holding a certain temperature and pressure for a certain period of time, to remove impurities of the thermal field device. Specific treatment temperatures, pressures and periods of thermal field 1#, thermal field 2#, thermal field 3#, thermal field 4# and thermal field 5# are shown in Table 1. The thermal field device in Table 1 includes the graphite crucible and the graphite thermal insulation felt.

**Table 1**

| | Temperature /°C | Pressure /mbar | Period /h |
|---|---|---|---|
| Thermal field 1# | 2,300 | 30 | 50 |
| Thermal field 2# | 1,800 | 5 | 100 |
| Thermal field 3# | 1,900 | 10 | 80 |
| Thermal field 4# | 2,400 | 40 | 30 |
| Thermal field 5# | 2,500 | 50 | 20 |

The silicon carbide powder in the graphite crucible during treatment processes of thermal field 1#, thermal field 2#, thermal field 3#, thermal field 4# and thermal field 5# is sublimated to form a high-temperature vapor, and the high-temperature vapor can infiltrate into the graphite crucible and the graphite thermal insulation felt during a dissipating process and expel impurity elements such as nitrogen adsorbed thereby, to obtain a high-purity graphite material, so as to remove impurities in thermal field 1#, thermal field 2#, thermal field 3#, thermal field 4# and thermal field 5# prepared, and control introduction of impurities in the process of preparing the semi-insulating silicon carbide single crystal.

### Embodiment 2: Preparation of semi-insulating silicon carbide single crystal initial product-mixing materials and crystal growth

A silicon carbide powder is doped with a vanadium element to prepare a silicon carbide powder doped with a small amount of vanadium; 0.01 g to 1 g of the vanadium element should be placed in each 1 kg of reaction silicon carbide powder; and a vanadium concentration in the silicon carbide powder after the reaction should be on an order of 1×10¹⁶ cm⁻³ to 1×10¹⁷ cm⁻³, to implement a content range of the vanadium element in a subsequent crystal growth process.

The silicon carbide powder doped with a small amount of vanadium is respectively placed in graphite crucibles of thermal field 1#, thermal field 2#, thermal field 3#, thermal field 4# and thermal field 5# after the treatment according to Embodiment 1, and the same are packaged into a crystal growth furnace to start a crystal growth step. The crystal growth step is illustrated with thermal field 1# as an example, and specific crystal growth conditions of the crystal growth step are shown in Table 2.

The crystal growth step according to this embodiment includes a high-temperature pretreatment stage and a crystal growth stage; and in the high-temperature pretreatment stage, impurities such as nitrogen adsorbed in the furnace are completely removed; an objective of this embodiment is to introduce a small amount of vanadium, and thus, as compared with a case of the high-purity semi-insulating silicon carbide single crystal, the step may greatly simplify a purification process by merely removing excess nitrogen, which can reduce technical costs and seed crystal costs as compared with the preparation process of the high-purity semi-insulating silicon carbide single crystal.

After the purification pretreatment in the furnace is completed, parameters of the crystal growth stage according to the present application are controlled so that the silicon carbide powder doped with a small amount of vanadium in the graphite crucible is fully sublimated, a sublimated vapor and the released vanadium element are transported to the seed crystal along with a temperature gradient to crystallize. It can be known from a growth process of a heavily-doped semi-insulating silicon carbide single crystal that, the vanadium element occupies a part of lattice positions of a crystal growth interface during the crystal growth process, so as to implement doping of the vanadium element. The vanadium element contained in the silicon carbide powder doped with a small amount of vanadium has been limited to a content of 1×10¹⁶ cm⁻³ to 1×10¹⁷ cm⁻³, so after a vapor transport process, the concentration of the vanadium element finally doped into the silicon carbide single crystal should be between 5 × 10¹⁵ cm⁻³ and 1×10¹⁷ cm⁻³ with loss in the transport process and recombination of vanadium and the silicon carbide powder taken into account. The vanadium element entering the silicon carbide single crystal may exist both as a donor and as an acceptor, so as to compensate for the shallow-energy-level impurities in the silicon carbide single crystal.

### Embodiment 3: Preparation of semi-insulating silicon carbide single crystal-annealing

The silicon carbide single crystal initial product prepared in Embodiment 2 is further annealed to obtain the semi-insulating silicon carbide single crystal. The step of preparing the silicon carbide single crystal is illustrated with an annealing treatment performed on a silicon carbide single crystal initial product prepared by using a silicon carbide single crystal growth step with thermal field 1# as an example. Thermal field 1# according to Embodiment 2 respectively undergoes crystal growth steps in Table 2 to prepared the semi-insulating silicon carbide single crystal initial product, which is annealed to be respectively prepared into silicon carbide single crystal 1#, silicon carbide single crystal 2#, silicon carbide single crystal 3#, silicon carbide single crystal 4# and silicon carbide single crystal 5#; and specific annealing treatment conditions are shown in Table 2.

After the growth of the silicon carbide single crystal is completed, the silicon carbide single crystal is taken out of the graphite crucible. Since a growth interface is at a relatively high temperature during the growth of the silicon carbide single crystal, some atoms at the growth interface break away from lattice positions to form intrinsic point defects of a certain concentration. By placing the silicon carbide single crystal in the annealing furnace and annealing at a temperature of 1,800 °C to 2,000 °C for 10 h to 50 h, the intrinsic point defects may be removed. In the annealing process, the intrinsic point defects existing in the silicon carbide single crystal annihilate through migration, and the concentration of the intrinsic point defects is lowered to a level below its intrinsic concentration at room temperature that does not affect electrical properties of the crystal. So far, a resistivity of the silicon carbide single crystal prepared in the present application is determined by residual shallow-energy-level impurities and a small amount of vanadium. Since the shallow-energy-level impurities and a small amount of vanadium all occupy lattice positions, they have very high thermal stability, which means that the silicon carbide single crystal according to the present application can obtain a highly stable resistivity.

**Table 2**

| Product | Parameters of high-temperature pretreatment stage | Parameters of crystal growth stage | Parameters of annealing stage |
|---|---|---|---|
| Silicon carbide single crystal 1# | Temperature: 1,500 °C | Reducing a pressure to 25 mbar while raising a temperature to 2,300 °C at a rate of 30 °C/min | Holding a temperature of 2,100 °C for 30 h |
| | Pressure: 900 mbar | | |
| | Holding period: 30 h | | |
| Silicon carbide single crystal 2# | Temperature: 1,200 °C | Reducing a pressure to 50 mbar while raising a temperature to 2,300 °C at a rate of 10 °C/min | Holding a temperature of 1,800 °C for 50 h |
| | Pressure: 800 mbar | | |
| | Holding period: 50 h | | |
| Silicon carbide single crystal 3# | Temperature: 2,000 °C | Reducing a pressure to 5 mbar while raising a temperature to 2,300 °C at a rate of 50 °C/min | Holding a temperature at 2,200 °C for 10 h |
| | Pressure: 1,000 mbar | | |
| | Holding period: 5h | | |
| Silicon carbide single crystal 4# | Temperature: 1,400 °C | Reducing a pressure to 10 mbar while raising a temperature to 2,400 °C at a rate of 15 °C/min | Holding a temperature of 1,900 °C for 15 h |
| | Pressure: 850 mbar | | |
| | Holding period: 40 h | | |
| Silicon carbide single crystal 5# | Temperature: 1,800 °C | Reducing s pressure to 40 mbar while raising temperature to 2,400 °C at a rate of 45 °C/min | Holding a temperature of 2,000 °C for 40 h |
| | Pressure: 950 mbar | | |
| | Holding period: 15 h | | |

Since the growth interface is at a relatively high temperature during the crystal growth process, some atoms at the growth interface break away from lattice positions to form point defects of a certain concentration. Through annealing according to the present application, the point defects existing in the crystal annihilate through migration, so that the concentration decreases to a level that does not affect the electrical properties of the crystal. So far, the resistivity of the crystal prepared is determined by the residual shallow-energy-level impurities and a small amount of vanadium. Since these shallow-energy-level impurities and a small amount of vanadium all occupy lattice positions, they have very high thermal stability, which means that the crystal can obtain a highly stable resistivity.

### Embodiment 4: Characterization of semi-insulating silicon carbide single crystal

Resistivity, crystal form, impurity content, intrinsic point defect and resistivity of the silicon carbide single crystal prepared in Embodiment 3 are tested; the test results show that the silicon carbide single crystal prepared has high a semi-insulation property and high a resistivity, and a mean resistivity change value after an epitaxial annealing process (900 °C to 1200 °C/0.5 h to 10 h) of less than 55%. Results of the resistivity, the crystal form, the impurity content, the intrinsic point defect and the resistivity tested are illustrated with silicon carbide single crystal 1#, silicon carbide single crystal 2#, silicon carbide single crystal 3#, silicon carbide single crystal 4# and silicon carbide single crystal 5# as an example, as shown in Table 3, in which the shallow-energy-level impurity content includes N, B and Al.

**Table 3**

| Sample serial number | Initial resistivity /Ω·cm | Crystal form | Vanadium content /cm⁻³ | Shallow-energy-level impurity content /cm⁻³ | Intrinsic point defect /cm^{- 3} | Mean resistivity attenuation rate after 1200 °C/2 h |
|---|---|---|---|---|---|---|
| Silicon carbide single crystal 1# | 4.22×10¹¹ | 4H-SiC | 7.26×10¹⁵ | 7.43×10¹⁵ | < 1×10¹⁴ | 25% |
| Silicon carbide single crystal 2# | 3.82×10¹¹ | 4H-SiC | 2.49×10¹⁶ | 2.60×10¹⁶ | < 1×10¹⁵ | 53% |
| Silicon carbide single crystal 3# | 2.01×10¹¹ | 4H-SiC | 4.36×10¹⁵ | 4.41×10¹⁵ | < ×10¹⁴ | 31% |
| Silicon carbide single crystal 4# | 1.92×10¹¹ | 6H-SiC | 1.04×10¹⁶ | 1.07×10¹⁶ | < ×10¹⁴ | 42% |
| Silicon carbide single crystal 5# | 1.10×10¹¹ | 6H-SiC | 5.61x10¹⁵ | 5.53×10¹⁵ | < ×10¹⁴ | 51% |

### Embodiment 5: Performance test of semi-insulating silicon carbide single crystal substrate

The silicon carbide single crystal prepared in Embodiment 3 is cut, grounding and polished respectively to obtain 4-to-8-inch semi-insulating silicon carbide single crystal substrates, then the obtained semi-insulating silicon carbide single crystal substrates are annealed, and meanwhile, resistivity tests and surface tests are performed on the silicon carbide single crystal substrates before and after annealing; test results show that the silicon carbide single crystal substrates prepared in Embodiment 3 have good electrical performance stability and an extremely small inner stress.

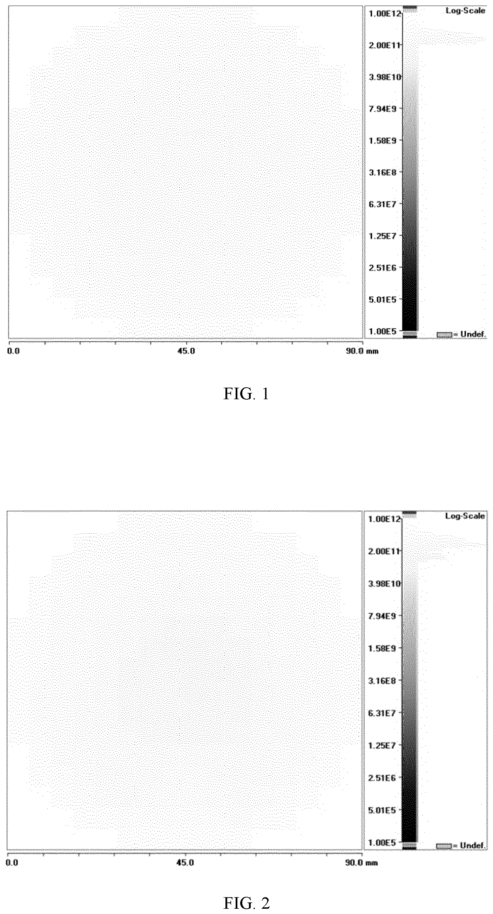

It is illustrated with 4-inch silicon carbide single crystal substrate 1# prepared from silicon carbide single crystal 1# as an example. Silicon carbide single crystal substrate 1# was annealed at 1,200 °C for 2 h. A surface scanning chart of a resistivity of silicon carbide single crystal substrate 1# before annealing is as shown in FIG. 1, and a surface scanning chart of a resistivity of silicon carbide single crystal substrate 1# after annealing is as shown in FIG. 2. It is tested that a resistivity mean is changed from 4.22×10¹¹ Ω•cm to 3.17×10¹¹ Ω•cm, and the resistivity is attenuated by < 50%; meanwhile, surface tests before and after annealing silicon carbide single crystal substrate 1# are performed: before and after annealing, silicon carbide single crystal substrate 1# has a WARP value changed from 8.35 µm to 8.42 µm, a BOW value changed from 9.62 µm to 9.87 µm, and changes of absolute values of Bow and Warp are far smaller than a 5-µm control line before and after annealing as required by the epitaxial process, which indicates that an inner stress of the silicon carbide single crystal substrate is extremely small, so that the substrate can be ensured to have excellent surface quality, so as to guarantee stability and consistency of quality of the silicon carbide single crystal substrate in the subsequent epitaxy process.

The above are only embodiments of the present application, but the scope of the present application is not limited by these specific embodiments, and is determined by the claims of the present application. Various changes and modifications may be made to the present application by those skilled in the art. Any modification, equivalent substitution, improvement, and the like, made within the technical spirit and principles of the present application should be covered within the protection scope of the present application.

## Claims

1. A high-quality semi-insulating silicon carbide single crystal doped with a small amount of vanadium, comprising shallow-energy-level impurities, a low-concentration deep-energy-level dopant, and a very small amount of intrinsic point defects;
wherein, the shallow-energy-level impurities are compensated by the deep-energy-level dopant and the intrinsic point defects together, a concentration of the deep-energy-level dopant is lower than a concentration of a deep-energy-level dopant in a doped semi-insulating silicon carbide single crystal;
a concentration of the intrinsic point defects is a primary concentration of intrinsic point defects in the silicon carbide single crystal at room temperature, and stability of electrical properties of the silicon carbide single crystal is not affected by the concentration of the intrinsic point defects.

2. The semi-insulating silicon carbide single crystal according to claim 1, wherein, a sum of concentrations of the shallow-energy-level impurities is lower than 1×10¹⁷ cm⁻³, the concentration of the deep-energy-level dopant is lower than 1×10¹⁷ cm⁻³, and the concentration of the intrinsic point defects at room temperature is not higher than 1×10¹⁵ cm⁻³.

3. The semi-insulating silicon carbide single crystal according to claim 2, wherein, the sum of the concentrations of the shallow-energy-level impurities is not lower than 1×10¹⁵ cm⁻³, the concentration of the deep-energy-level dopant is not lower than 1×10¹⁵ cm⁻³, and the concentration of the intrinsic point defects at room temperature is not higher than 1×10¹⁴ cm⁻³.

4. The semi-insulating silicon carbide single crystal according to claim 3, wherein, the sum of the concentrations of the shallow-energy-level impurities is not lower than 5×10¹⁵ cm⁻³.

5. The semi-insulating silicon carbide single crystal according to claim 4, wherein, the sum of the concentrations of the shallow-energy-level impurities is not lower than 1×10¹⁶ cm⁻³.

6. The semi-insulating silicon carbide single crystal according to claim 1, wherein, the shallow-energy-level impurities include one or more of the IIIA and VA main family elements in the periodic table of elements.

7. The semi-insulating silicon carbide single crystal according to claim 1, wherein, the deep-energy-level dopant is selected from at least one of the VB family elements in the periodic table of elements.

8. The semi-insulating silicon carbide single crystal according to claim 7, wherein, the deep-energy-level dopant is vanadium.

9. The semi-insulating silicon carbide single crystal according to claim 1, wherein, a crystal form of the silicon carbide single crystal is 4H-SiC, 6H-SiC or 3C-SiC.

10. The semi-insulating silicon carbide single crystal according to claim 1, wherein, it is prepared by using a method comprising steps of:
1) removing impurities of a thermal field device: performing high-temperature purification on a graphite thermal insulation structure and a graphite crucible;
2) mixing materials: doping a deep-energy-level dopant element in a silicon carbide powder, a concentration of the deep-energy-level dopant in the silicon carbide powder being 1×10¹⁶ cm⁻³ to 1×10¹⁷ cm⁻³;
3) crystal growth: starting a crystal growth step after placing the silicon carbide powder doped with the deep-energy-level dopant element prepared in step 2) in the graphite crucible treated in step 1), a concentration of a deep-energy-level doping center element after an end of the crystal growth step being 5×10¹⁵ cm⁻³ to 1×10¹⁷ cm⁻³; and
4) annealing: annealing the silicon carbide single crystal treated in step 3).

11. A semi-insulating silicon carbide single crystal substrate, prepared from the semi-insulating silicon carbide single crystal according to any one of claims 1 to 10.

12. The semi-insulating silicon carbide single crystal substrate according to claim 11, wherein, a mean resistivity change value of the silicon carbide single crystal substrate before and after an epitaxial annealing process is less than 55%;
preferably, a mean resistivity change value of the silicon carbide single crystal before and after a treatment of holding a temperature of 900 °C to 1,200 °C for 0.5 h to 10 h is less than 55%; and
more preferably, the mean resistivity change value of the silicon carbide single crystal substrate before and after the treatment of holding the temperature of 900 °C to 1,200 °C for 0.5 h to 10 h is less than 50%.

13. An epitaxial wafer and/or a transistor, comprising the semi-insulating silicon carbide single crystal substrate according to claim 11 or 12.

14. A preparation method of a high-quality semi-insulating silicon carbide single crystal doped with a small amount of vanadium, comprising steps of:
1) removing impurities of a thermal field device;
2) mixing materials: doping a certain amount of deep-energy-level dopant into a silicon carbide powder;
3) crystal growth: starting crystal growth after placing the silicon carbide powder doped with the deep-energy-level dopant prepared in step 2) in the thermal field device treated in step 1), a concentration of a deep-energy-level doping center element after an end of crystal growth being 5×10¹⁵ cm⁻³ to 1×10¹⁷ cm⁻³;
4) annealing: annealing a silicon carbide single crystal initial product treated in step 3), to obtain the semi-insulating silicon carbide single crystal.

15. The preparation method according to claim 14, wherein, the semi-insulating silicon carbide single crystal comprises shallow-energy-level impurities, a deep-energy-level dopant, and a very small amount of intrinsic point defects; wherein, the shallow-energy-level impurities are compensated by the deep-energy-level dopant and the intrinsic point defects together, a concentration of the deep-energy-level dopant is lower than a concentration of a deep-energy-level dopant in a doped semi-insulating silicon carbide single crystal; a concentration of the intrinsic point defects is not higher than 1×10¹⁵ cm⁻³ at room temperature, such that stability of electrical properties of the silicon carbide crystal is not affected.

16. The preparation method according to claim 15, wherein, a sum of concentrations of the shallow-energy-level impurities is lower than 1×10¹⁷ cm⁻³, the concentration of the deep-energy-level dopant is lower than 1×10¹⁷ cm⁻³, and the concentration of the intrinsic point defects at room temperature is not higher than 1×10¹⁴ cm⁻³;
preferably, the shallow-energy-level impurities include one or more of the IIIA and VA main family elements in the periodic table of elements.

17. The preparation method according to claim 15, wherein, the deep-energy-level dopant is selected from at least one of the VB family elements in the periodic table of elements; preferably, the deep-energy-level dopant is a vanadium element.

18. The method according to claim 14, wherein, the thermal field device includes a graphite thermal insulation structure and a graphite crucible.

19. The preparation method according to claim 14, wherein, the removing impurities of a thermal field device of step 1) includes: holding a temperature of 1,800 °C to 2,500 °C and a pressure of 5 mbar to 50 mbar for 20 h to 100 h after placing the silicon carbide powder in the graphite crucible.

20. The preparation method according to claim 14, wherein, a concentration of the deep-energy-level dopant element in the mixture of step 2) is 1×10¹⁶ cm⁻³ to 1×10¹⁷ cm⁻³.

21. The preparation method according to claim 14, wherein, the crystal growth step in step 3) includes: a high-temperature pretreatment stage and a crystal growth stage;
the high-temperature pretreatment stage includes: holding a temperature of 1,800 °C to 2,000 °C and a pressure of 800 mbar to 900 mbar for 30 h to 50 h;
a condition for the crystal growth stage is: reducing the pressure to 5 mbar to 50 mbar while raising the temperature to above 2,200 °C at a rate of 10 °C/min to 30 °C/min.

22. The preparation method according to claim 14, wherein, a condition for annealing of step 4) is: placing the silicon carbide single crystal initial product prepared in step 3) in an annealing furnace and holding a temperature of 1,800 °C to 2,200 °C for 10 h to 50 h.

23. A high-quality semi-insulating silicon carbide single crystal doped with a small amount of vanadium, prepared by using the method according to any one of claims 14 to 22.

24. A preparation method of a high-quality semi-insulating silicon carbide single crystal substrate doped with a small amount of vanadium, comprising: cutting, grinding and polishing the high-quality semi-insulating silicon carbide single crystal doped with a small amount of vanadium according to claim 23, to obtain the semi-insulating silicon carbide single crystal substrate.

25. The semi-insulating silicon carbide single crystal according to claim 23 and/or the semi-insulating silicon carbide single crystal substrate prepared by using the preparation method according to claim 10, being applied in preparation of an epitaxial wafer and/or a transistor.
